(19) Europäisches Patentamt
European Patent Office
Office européen des brevets

(11) **EP 4 462 144 A1**

(12) **EUROPEAN PATENT APPLICATION**

(43) Date of publication:
**13.11.2024 Bulletin 2024/46**

(21) Application number: **23173266.0**

(22) Date of filing: **12.05.2023**

(51) International Patent Classification (IPC):
**G01R 33/022** (2006.01)   **G01R 33/028** (2006.01)
**G01P 15/08** (2006.01)

(52) Cooperative Patent Classification (CPC):
**G01R 33/0286; G01R 33/022;** G01P 15/105;
G01P 15/125

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **Melexis Technologies SA**
**2022 Bevaix (CH)**
• **CSEM**
**Centre Suisse d'Electronique et de Microtechnique SA**
**2002 Neuchâtel (CH)**

(72) Inventors:
• **CLOSE, Gael**
**2022 Bevaix (CH)**
• **TORMEN, Maurizio**
**2022 Bevaix (CH)**
• **GASPARIN, Enrico**
**2022 Bevaix (CH)**
• **HOOGERWERF, Arnold Christiaan**
**2002 Neuchâtel (CH)**
• **BAYAT, Dara**
**2002 Neuchâtel (CH)**
• **DESPONT, Michel**
**2002 Neuchâtel (CH)**

(74) Representative: **Jacobs, Lambert**
**Inventrans BV**
**Overwegstraat 24**
**3740 Bilzen (BE)**

(54) **MAGNETIC FIELD GRADIENT SENSOR**

(57)  A MEMS structure (100) comprising: a first platform (101) comprising a first material, and further comprising an object or layer of a second, magnetic material (M2), having a first magnetization; and a second platform (102) comprising a third material, and optionally further comprising an object or layer of a fourth material (M4) being a non-magnetic material, or being magnetic and having a second magnetization different from the first magnetization; the first platform and the second platform being movable in a first direction (X) caused by an ambient acceleration and/or by an ambient magnetic field gradient; at least one sensor (51). A sensor device comprising said MEMS structure and a processing circuit (111) connected to said sensor. A method (900) of determining a magnetic field gradient using said MEMS structure.

**FIG. 1**

**EP 4 462 144 A1**

## Description

### Field of the invention

The present invention relates in general to the field of magnetic sensor devices, and more in particular to a MEMS structure, and sensor devices comprising such a MEMS structure. The present invention also relates to a method of measuring a magnetic field gradient using such a MEMS structure.

### Background of the invention

Micro-Electro-Mechanical (MEMS) devices and methods of producing them are known in the art of the semiconductor industry. They typically comprise very small mechanical structures (e.g. smaller than 1.0 cm) with movable parts. Examples are an accelerometer, a gyroscope, a magnetometer, etc.

WO2014151370(A1) describes a MEMS device with a first and a second proof mass, and sensors operable to sense a motion of the proof mass caused by an ambient acceleration and/or an ambient magnetic field.

There is always room for improvements or alternatives.

### Summary of the invention

It is an object of embodiments of the present invention to provide a sensor structure or a sensor arrangement or a sensor device capable of measuring a magnetic field gradient.

It is an object of embodiments of the present invention to provide a MEMS structure capable of measuring a magnetic field gradient.

It is also an object of embodiments of the present invention to provide such a structure or arrangement or device that has a reduced sensitivity to mechanical acceleration(s).

It is also an object of embodiments of the present invention to provide a method of measuring a signal indicative of a magnetic field gradient, or a magnetic field gradient.

According to a first aspect, the present invention provides a MEMS structure comprising: a first platform (or "first proof mass" or "first support") comprising a first material, and further comprising at least one object or at least one layer of a second material (e.g. M2) embedded in or mounted to or disposed on the first platform, the second material being a magnetic material having a first magnetization; a first flexible suspension (e.g. comprising a first and a second flexible beam, or comprising two flexible zig-zag structures) anchored to a substrate (e.g. directly anchored to the substrate, or indirectly anchored to the substrate via a "support beam") to support or suspend the first platform, while allowing a first movement of the first platform in a first direction (e.g. X) caused by an ambient force or acceleration and/or by an ambient magnetic field gradient; a second platform (or "second proof mass" or "second support") comprising a third material, and optionally further comprising at least one object or at least one layer of a fourth material (e.g. M4) embedded in or mounted to or disposed on the second platform, the fourth material being a non-magnetic material or being a magnetic material having a second magnetization different from the first magnetization (e.g. different magnitude and/or different orientation); a second flexible suspension (e.g. comprising a third and a fourth flexible beam, or comprising two flexible zig-zag structures) anchored (e.g. directly or indirectly via a support beam) to said substrate to support or suspend the second platform, while allowing a second movement of the second platform in said first direction (e.g. X) caused by said ambient force or acceleration and/or by said ambient magnetic field gradient; at least one sensor (e.g. at least one sensing element, or at least one sensing structure, or at least one "sensing means") configured for measuring at least one of the following: a characteristic of the first movement (e.g. a displacement or a deflection or a first vibration frequency), a characteristic of the second movement (e.g. a displacement or a deflection or a second vibration frequency), a characteristic of a difference between the first movement and the second movement (e.g. a relative displacement or a relative deflection or a vibration frequency).

In an embodiment, the "first magnetization" may be representable by a first magnetization vector, and the second magnetization may be representable by a second magnetization vector, different from the first magnetization vector.

The substrate may be a semiconductor substrate.

The term "platform" or "test mass" or "proof mass" mean the same.

The term "ambient magnetic field" refers to any magnetic field other than the magnetic field created by the magnetic material on the first and/or second platform.

This MEMS structure can be used as a "magnetic gradiometer", i.e. an integrated sensor device that is sensitive to a magnetic field gradient (e.g. dBx/dx, dBy/dx, dBz/dx) along a certain direction X. The MEMS structure may be based on an accelerometer structure.

In contrast to the prior art, the first and the second platform are preferably not directly mechanically coupled to each other, for example, they are not directly interconnected via a single flexible interconnection (e.g. there is no rhombus shaped coupling between the two platforms). Instead, each of the first and second platform is mechanically connected to a common substrate via said first and said second flexible suspension respectively.

In an embodiment, the first platform has a magnetized magnetic material, and the second platform does not have a magnetic material.

In another embodiment, the first platform has a first magnetized magnetic material, and the second platform has a second magnetized magnetic material, but the first magnetic material is magnetized differently than the second magnetic material in terms of magnitude and/or direction.

In preferred embodiments, there is no direct mechanical connection between the first platform and the second platform, hence, the second platform can move independently from the first platform. Or stated in other words, preferably the first platform is movable independently from the second platform. Since both platforms are subjected to the same mechanical acceleration or gravitational force, they will typically (at least as a first approximation) move (e.g. displace or vibrate) substantially in the same manner due to such acceleration or gravitation. However, in the presence of a magnetic field gradient, they will move differently. Hence, by considering the movement of the second platform as a reference movement, the influence of acceleration and/or gravitation on the first platform can be reduced or at least partially compensated.

The first material may comprise a semiconductor material, e.g. Si. The first material may for example comprise Si and/or $SiO_2$. The first material is a non-magnetic material.

The second material is a magnetic material, e.g. FeNi or NdFeB or an alloy comprising any combination of Co, Fe and Ni.

The third material may comprise a semiconductor material, e.g. Si. The third material may for example comprise Si and/or $SiO_2$. The third material is a non-magnetic material.

The fourth material may be or may comprise a magnetic material, or may be or may comprise a non-magnetic material. If the fourth material is magnetic, it has a magnetization different than that of the second material.

In an embodiment, the fourth material is the same as the second material.

In an embodiment, the fourth material is different from the second material.

In an embodiment, the fourth material is different from the third material.

In an embodiment, the fourth material comprises Si and/or $SiO_2$. This simplifies the production or assembly, since the second mass does not have to be deposited or attached to the second platform.

In an embodiment, each of the second and the fourth material is a hard magnetic material.

In an embodiment, each of the second and the fourth material is a soft magnetic material.

In an embodiment, the second material is a soft magnetic material, and the fourth material is a hard magnetic material.

In an embodiment, the second material is a hard magnetic material, and the fourth material is a soft magnetic material. The first and second flexible suspension is more flexible in the first direction (X), than in the Y and Z-direction.

In an embodiment, the shape and size of the first platform itself (i.e. excluding the second material) is substantially identical to the shape and size of the second platform itself (i.e. excluding the fourth material). In this case, the mass of the second material is preferably substantially the same as the mass of the fourth material, which could mean that the volume of second material may be quite different from the volume of fourth material, if the specific mass of the second material is quite different from the specific mass of the fourth material.

In an embodiment, the shape and size of the first platform itself (i.e. excluding the second material) is different from the shape and size of the second platform itself (i.e. excluding the fourth material). In this case, the fourth material may be absent, or may have a specific mass quite different from (e.g. smaller than) the specific mass of the second material.

In an embodiment, the second material (e.g. M2) is a hard-magnetic material, and the fourth material (e.g. M4) is a non-magnetic material. The hard-magnetic material has a first magnetization with a magnitude different from zero.

In an embodiment, the second material (e.g. M2) is a hard-magnetic material, and the fourth material (e.g. M4) is also a hard-magnetic material. The second material has a first magnetization with a magnitude different from zero. The fourth material has a second magnetization different from the first magnetization (e.g. different in amplitude and/or different in orientation). The second material may have a relatively strong magnetization. The fourth material may have a relatively weak magnetization.

In an embodiment, the second material (e.g. M2) is a hard-magnetic material, and the fourth material (e.g. M4) is a soft-magnetic material. The second material has a first magnetization with a magnitude different from zero. The fourth material has a magnetization equal to zero.

In an embodiment, the second material (e.g. M2) is a soft-magnetic material, and the fourth material (e.g. M4) is a non-magnetic material. The soft-magnetic material may have a first magnetization with a magnitude equal to zero.

In an embodiment, the fourth material is present, and is also a magnetic material, which is magnetized in a direction substantially opposite to the magnetization of the second material.

This offers the advantage that the two platforms will move in opposite directions (e.g. towards each other, or away from each other) under a magnetic field gradient, if the magnitude of the magnetization of the second material and the fourth material is substantially the same, the signal will be twice as large as compared to an embodiment where the second material is non-magnetic, thus the accuracy will be improved, because the signal-to-noise ratio (SNR) will be improved. It is noted however, that the second material and the fourth material does not have to be the same.

In an embodiment, the first platform together with the second material (e.g. M2) has a first total mass; and the second platform together with the fourth material (e.g. M4), if present, has a second total mass; and the first total mass is substantially equal to the second total mass within a tolerance margin smaller than $\pm10\%$, or smaller than $\pm8\%$, or smaller than $\pm5\%$, or smaller than $\pm3\%$, or smaller than $\pm2\%$, or smaller than $\pm1\%$, or smaller than $\pm0.5\%$.

Preferably the "first total mass" (e.g. expressed in kg) and the "second total mass" are approximately equal, e.g. within a certain tolerance margin smaller than $\pm10\%$, or smaller than $\pm8\%$, or smaller than $\pm5\%$, or smaller than $\pm3\%$, or smaller than $\pm2\%$, or smaller than $\pm1\%$, or smaller than $\pm0.5\%$, such that the mechanical behaviour (e.g. static movement or dynamic vibration) of the first and second platform due to gravity and/or due to mechanical acceleration and/or due to mechanical vibrations, is approximately the same, so by considering a difference in mechanical behaviour of the first and second platform, the influence from gravity, acceleration and vibrations can be largely reduced, or substantially eliminated, and only or mainly the influence of a magnetic field gradient remains.

In an embodiment, the first suspension comprises a first flexible beam and a second flexible beam; and the second suspension comprises a third flexible beam and a fourth flexible beam.

Each flexible beam may comprise one or more elongated portions extending mainly in a second direction (Y) perpendicular to the first direction (X).

The elongated beam portions may be substantially rectilinear.

The first, second, third and fourth beam are shaped and sized to be relatively flexible in the first direction (e.g. capable of bending in the X-direction), and to be relatively stiff in the other directions (e.g. in the Y and Z-direction).

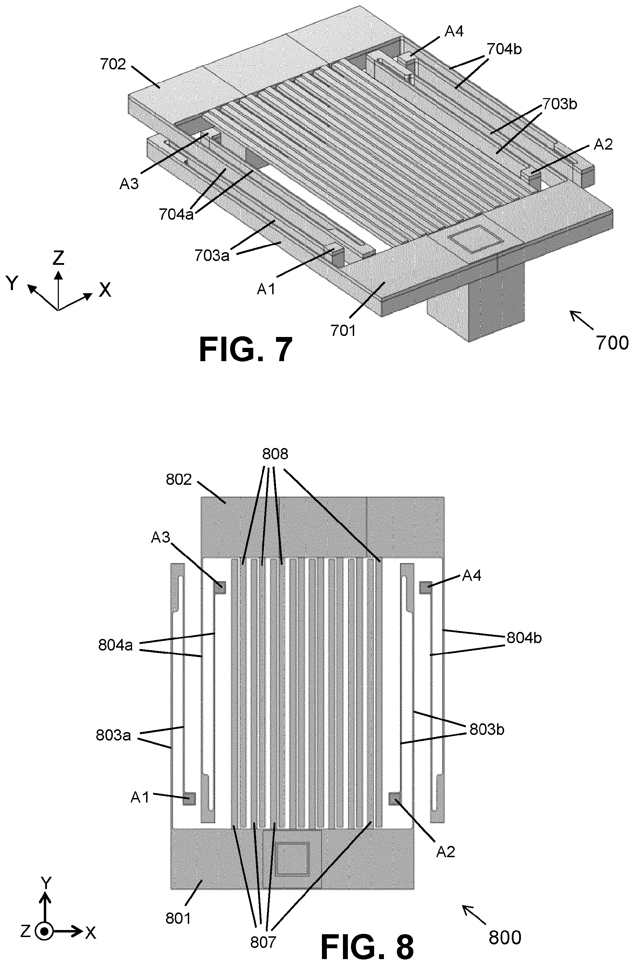

In an embodiment, the elongated beams have a U-shape comprising two or more elongated portions extending mainly in the second direction (e.g. as illustrated in FIG. 7 and FIG. 8).

In an embodiment, the MEMS structure further comprises a support beam (e.g. a fifth elongated beam) suspended to the substrate; wherein the support beam is connected (or anchored) to the substrate near a middle of the support beam; and wherein the first suspension and the second suspension are connected to said support beam on opposite sides of said middle.

Thus, for example, the first platform is suspended by means of a first and a second beam, and the first and the second beam are interconnecting the first platform and the support beam, and the second platform is suspended by means of a third and a fourth beam, and the third and the fourth beam are connecting the second platform and said support beam.

The support beam may provide a coupling between the first and second platform, when they are vibrating.

In an embodiment, the at least one sensor is configured for providing a signal indicative of a displacement of the first platform relative to the second platform; or the at least one sensor is configured for providing a signal indicative of a displacement of the first platform relative to the substrate. In the latter case, the MEMS structure may further comprise a second sensor configured for providing a signal indicative of a displacement of the second platform relative to the substrate.

In an embodiment, the at least one sensor comprises a capacitive sensor, or a piezoelectrical sensor, or a piezoresistive sensor, or an optical sensor.

The capacitive sensor may be configured for measuring a displacement of one structure with respect to another. The at least one capacitive sensor may be a variable capacitor comprising a plurality of parallel plate electrodes or linear comb fingers.

In an embodiment, the substrate is a silicon-on-insulator (SOI) substrate.

Preferably both sides (e.g. a top side and a bottom side) of the SOI substrate are etched.

It is noted, however, that the present invention will also work with other substrates, e.g. a silicon or CMOS substrate.

In an embodiment, the first platform and the second platform are formed at least partially above one another, in a direction perpendicular to a surface (e.g. a top surface) of the substrate. This may result in a smaller footprint.

In an embodiment, one of the first and second platform is implemented mainly in a lower silicon layer of the SOI substrate (also referred to as "bulk"), and the other of said first and second platform is implemented mainly in an upper silicon layer of the SOI substrate (also referred to as "device layer"), or vice versa. The upper layer (or device layer) may have a first thickness (T1), and the lower layer (bulk) may have a second thickness (T2) different from the first thickness. The thickness of the bulk layer may be 2.0 to 8.0 times larger than the thickness of the device layer, or 3.0 to 7.0 times, or 4.0 to 6.0 times.

In an embodiment, the first platform has a first maximum thickness in a direction perpendicular to the substrate, and the second platform has a second maximum thickness in a direction perpendicular to the substrate, and the first maximum thickness is different from the second maximum thickness.

It is noted that the thickness of the first platform may not be constant over the entire platform, but may be locally increased for accommodating the second mass in the form of a discrete object.

It is noted that an average thickness of the second platform may be larger than an average thickness of the first platform. This may for example be the case in an embodiment where the fourth material is absent and the second platform itself has an increased thickness.

In an embodiment, the first maximum thickness is smaller than the second maximum thickness.

In an embodiment, the first maximum thickness is larger than the second maximum thickness.

In an embodiment, the first platform has a first average thickness in a direction perpendicular to the substrate, and the second platform has a second average thickness in a direction perpendicular to the substrate, and the first average thickness is different from the second average thickness.

In an embodiment, the first average thickness is smaller than the second average thickness.

In an embodiment, the first average thickness is larger than the second average thickness.

In an embodiment, the first platform (excluding the second material) has a first average thickness, and the second platform (excluding the fourth material) has a second average thickness substantially equal to the first average thickness.

In an embodiment, the first platform without the second material has a first size and shape, and the second platform without the fourth material has a second size and shape, different from the first size and shape.

In an embodiment, the first platform without the second material has a first size and shape, and the second platform without the fourth material has a second size and shape, equal to the first size and shape.

In an embodiment, the first platform has a cavity; and the second material (e.g. M2) is part of a discrete object that is mounted or positioned inside said cavity.

In an embodiment, the second material (e.g. M2) is mounted on or to the first platform in the form of a solid object. This object may be glued to the first platform. The object may be situated, fully or partially, in a cavity made in the first platform.

In an embodiment, at least a portion of the second material (e.g. M2) is sputtered on the first platform. As mentioned above, the second material is a magnetic material.

In an embodiment, the second material (e.g. M2) is a magnetic material (e.g. FeNi or NdFeB or an alloy comprising any combination of Co, Fe and Ni); and the fourth material (e.g. M4) is a semiconductor material (e.g. Si) or an oxide (e.g. $SiO_2$).

In an embodiment, the MEMS structure further comprises at least one actuator for biasing one or both of the first platform and the second platform, e.g. an electrostatic actuator.

The actuator may be used to balance the system, and/or to create or compensate for an offset between the first and the second platform.

The MEMS device may further comprise a control circuit (not shown) to statically or dynamically bias the second platform.

In an embodiment, the MEMS structure further comprising a first actuator for causing an oscillation of the first platform; and further comprising a second actuator for causing an oscillation of the second platform. The MEMS structure may further comprise a first sensor for measuring a characteristic of the movement of the first platform, and a second sensor for measuring a characteristic of the movement of the second platform, or at least one sensor for measuring a characteristic of a movement of the first platform relative to the second platform. These sensors or this at least one sensor may be connected to a circuit which is configured for determining a resonance frequency of the movement of the first platform relative to the second platform. This circuit may be implemented on the same substrate as the MEMS structure, or on another substrate. The substrate containing said circuit may further comprise an excitation circuit to bring the first platform and the second platform in a vibrating state, e.g. by applying an alternating signal having a predefined amplitude.

The first actuator and/or the second actuator may be used to balance the system, and/or to create or compensate for an offset between the first and the second platform, and/or to bring the first platform and the second platform into vibrating state.

It is noted that the structure does not need to operate at the resonance frequency. In an embodiment, the structure is operated at a frequency below (e.g. slightly below) the resonance frequency. In another embodiment, the structure is operated at a frequency above (e.g. slightly above) the resonance frequency.

In an embodiment, the MEMS structure comprises only a single sensor, and is a magnetic gradiometer in a single direction (e.g. X).

According to a second aspect, the present invention also provides a sensor device comprising: one or more MEMS structures according to the first aspect.

In an embodiment, the sensor device comprises at least one or only one MEMS structure according to the first aspect. This sensor device can be referred to as a "one-dimensional magnetic gradient sensor".

In an embodiment, the sensor device comprises at least two or only two MEMS structures according to the first aspect, configured for measuring two magnetic field gradients, e.g. selected from the group consisting of dBx/dx, dBy/dx, dBz/dx, dBy/dx, dBy/dy, dBz/dy. This sensor device can be referred to as a "two-dimensional magnetic gradient sensor". The two MEMS structures may be 90° rotated relative to one another, about a Z-axis perpendicular to the substrate, and/or may comprise second materials magnetized in different directions. The latter may be achieved e.g. using micro-coils, or by incorporating discrete magnets oriented in different directions.

In an embodiment, the sensor device comprises at least three or only three MEMS structures according to the first aspect, configured for measuring three magnetic field gradients, e.g. selected from the group consisting of dBx/dx, dBy/dx, dBz/dx, dBy/dx, dBy/dy, dBz/dy. This sensor device may be referred to as a "three-dimensional magnetic gradient sensor".

In an embodiment, the sensor device comprises at least four or only four MEMS structures according to the first aspect, configured for measuring four magnetic field gradients, e.g. selected from the group consisting of dBx/dx, dBy/dx, dBz/dx, dBy/dx, dBy/dy, dBz/dy. This sensor device may be referred to as a "multi-dimensional magnetic gradient sensor".

In an embodiment, the sensor device comprises at least six or only six six MEMS structures according to the first aspect, configured for measuring six magnetic field gradients, e.g. selected from the group consisting of dBx/dx, dBy/dx, dBz/dx, dBy/dx, dBy/dy, dBz/dy. This sensor device may be referred to as a "multi-dimensional magnetic gradient sensor".

Any of these sensor devices (e.g. having only one up to six MEMS structures) may be an integrated sensor device, incorporated in a single package. This package may comprise one or more semiconductor substrates overmoulded by a molding compound.

In an embodiment, the sensor device further comprises **a circuit,** e.g. a processing circuit, configured for determining and optionally outputting one or more signals (or values) indicative of one or more magnetic field gradients, (e.g. selected from the group consisting of dBx/dx, dBy/dx, dBz/dx, dBy/dx, dBy/dy, dBz/dy) or one or more signals derived therefrom, e.g. a current value, a torque value, a force value, based on the one or more signals obtained from the at least one sensor of the one or more MEMS structures.

For example, the integrated sensor device may comprise a processing circuit, e.g. a digital processor, a non-volatile memory, etc. This circuit may be formed on a same substrate as the MEMS structure, or may be formed on a different substrate, but incorporated in the same package.

The circuit may be configured to determine the one or more magnetic field gradient(s) as a predefined function of the sensor signal(s) obtained from the one or more MEMS structures, for example as a linear function of the sensor signal.

According to a third aspect, the present invention also provides a method of measuring a magnetic field gradient or a signal indicative of a magnetic field gradient, the method comprising the steps of: a) providing a MEMS structure according to the first aspect, or providing an integrated sensor device according to the second aspect; b) obtaining at least one signal from the at least one sensor of the MEMS structure, the signal being indicative of a characteristic of a mechanical movement, which in turn is indicative of a magnetic field gradient.

In an embodiment, step a) comprises: providing said MEMS structure with at least one actuator, and step b) further comprises: biasing or activating said actuator; and step b) comprises: biasing or exciting said at least one sensor, e.g. by providing a DC current or a DC voltage, or by providing an AC current or an AC voltage, e.g. a sinusoidal current or voltage, or by providing one or more pulses to said at least one actuator.

The method may further comprise the step of converting said signal into a value of said magnetic field gradient, e.g. by applying a predefined function on said measured signal, e.g. a linear function, or a polynomial function having an order of at least two, or at least three.

It is an advantage of this method, that the magnetic field gradient thus determined is highly insensitive to a mechanical acceleration or gravitational field.

In an embodiment, the at least one sensor is a capacitive sensor, and the magnetic field gradient is determined in accordance with the formula: gradient = $K^*(Cm-C_0)$, where K is a predefined constant, Cm is the measured capacitance, and $C_0$ is a predefined capacitance value. The value of K and $C_0$ may be determined during a calibration procedure and may be stored in a non-volatile memory.

These and other aspects of the invention will be apparent from and elucidated with reference to the embodiment(s) described hereinafter.

**Brief description of the drawings**

**FIG. 1** shows a schematic representation of a MEMS structure according to an embodiment of the present invention.

The device comprises two "platforms" (also referred to as "proof mass") which are movable when subjected to an external acceleration and/or an external magnetic field gradient. The MEMS structure comprises at least one sensor.

**FIG. 2** shows a special case of FIG. 1, where the sensor is a capacitive sensor.

**FIG. 3** shows a MEMS structure according to an embodiment of the present invention, having two sensors.

**FIG. 4** shows a MEMS structure according to an embodiment of the present invention, having a biasing or actuator mechanism.

**FIG. 5** shows a MEMS structure according to an embodiment of the present invention, having a support beam from which the two platforms are suspended.

**FIG. 6** shows a MEMS structure according to an embodiment of the present invention, having a support beam, and a plurality of sensors, and a plurality of actuators.

**FIG. 7** shows a realistic representation of an illustrative example of a MEMS device according to an embodiment of the present invention, in perspective view.

**FIG. 8** shows the MEMS device of FIG. 7 in top view.

**FIG. 9** shows a flow-chart of a method of measuring a magnetic field gradient, or a signal indicative of a magnetic field gradient, proposed by the present invention, as may be performed using a MEMS structure as illustrated in FIG. 1 to FIG. 8.

**FIG. 10** shows a flow-chart of a method of measuring a magnetic field gradient, or a signal indicative of a magnetic field gradient, proposed by the present invention, as may be performed by a sensor device comprising a MEMS structure as illustrated in FIG. 1 to FIG. 8.

The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

## Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In this document, a MEMS device is a device comprising one or more MEMS structures, e.g. a semiconductor device comprising one or more MEMS structures.

In this document, the expression "platform" and "proof mass" or "support" mean the same. It refers to a rigid portion of a MEMS structure that is suspended by flexible means, and that is movable under external influences (e.g. mechanical acceleration). In the present invention, the "platform" itself may e.g. be composed of Si and/or $SiO_2$. An additional material (e.g. a magnetic material) may be added to the platform, e.g. in the form of a sputtered layer, or in the form of an object mounted to the platform.

Embodiments of the present invention are typically described using an orthogonal coordinate system which is fixed to a substrate, and having three axes X, Y, Z, where the X and Y axis are parallel to the substrate, and the Z-axis is perpendicular to the substrate.

In this document, a first sensor and a second sensor is typically referred to by S1, S2; whereas signals provided by these sensors are typically referred to by s1, s2.

In this document, the term "sensor" may refer to a "sensing element" or a "sensing structure" or "sensing means", e.g. a "transducer", e.g. "a mechanical to electrical transducer".

In this document, the expressions "a movement caused by an external force" and "a movement caused by an external acceleration" mean substantially the same. They refer for example to a movement or deflection caused by gravitational force.

In this document, the expression "first platform" may refer to the "first platform itself" without the second material", or may refer to the "first platform with the second material", depending on the context. Since the second material is fixedly connected to the first platform, the difference is irrelevant as far as displacement is concerned, but may be relevant regarding material, shape, size, mass.

In this document, the expression "first total mass" or "total mass of the first platform" refers to the sum of the mass of the first platform itself (e.g. composed of Si and/or $SiO_2$), and the mass of the second material which is fixedly connected to (e.g. mounted to, or deposited upon, or embedded in) the first platform.

In this document, the expression "second platform" may refer to the "second platform itself" without the fourth material", or may refer to the "second platform with the fourth material", depending on the context. Since the fourth material, if present, is fixedly connected to the second platform, the difference is irrelevant as far as displacement is concerned, but may be relevant regarding material, shape, size, mass.

In this document, the expression "second total mass" or "total mass of the second platform" refers to the mass of the second platform itself in case there is no fourth material, or refers to the sum of the mass of the second platform itself (e.g. composed of Si and/or $SiO_2$) and the mass of the fourth material which is fixedly connected to (e.g. mounted to, or deposited upon, or embedded in) the second platform.

The present invention is related to a magnetic sensor device, and more in particular to a magnetic sensor device comprising a MEMS (micro-electro-mechanical) structure used for measuring a magnetic field gradient. The MEMS device comprises:

- a first platform (or "first proof mass") comprising a first material. The first platform further comprises at least one object or at least one layer of a second material embedded in or mounted to or disposed on the first platform, the second material being a magnetic material having a first magnetization;
- a first flexible suspension (e.g. comprising a first and a second flexible beam) anchored to a substrate to support or suspend the first platform, while allowing a first movement of the first platform in a first direction caused by an ambient force or acceleration and/or by an ambient magnetic field gradient;
- a second platform (or "second proof mass") comprising a third material. The second platform may optionally further comprise at least one object or at least one layer of a fourth material embedded in or mounted to or disposed on the second platform. The fourth material, if present, may be a non-magnetic material or a magnetic material having a second magnetization different from the first magnetization (e.g. different magnitude and/or different orientation);
- a second flexible suspension (e.g. comprising a third and a fourth flexible beam) anchored to said substrate to suspend the second platform, while allowing a second movement of the second platform in said first direction caused by said ambient force or acceleration and/or by said ambient magnetic field gradient;

- at least one sensor (e.g. at least one sensing element, or at least one sensing structure, or at least one "sensing means") configured for measuring at least one of the following: a characteristic of the first movement (e.g. a displacement or a deflection or a first vibration frequency), a characteristic of the second movement (e.g. a displacement or a deflection or a second vibration frequency), a characteristic of a difference between the first movement and the second movement (e.g. a relative displacement or a relative deflection or a vibration frequency).

By considering the movement of the second platform as a reference movement, the influence of acceleration and/or gravitation on the first platform can be reduced or at least partially compensated, and the movement caused by the magnetic field gradient can be determined.

The present invention is also related to a method of measuring a signal indicative of a magnetic field gradient.

It is an advantage of this method, that the magnetic field gradient thus determined is highly insensitive to a mechanical acceleration or to a gravitational field.

These are the main principles underlying the present invention.

Referring now to the Figures.

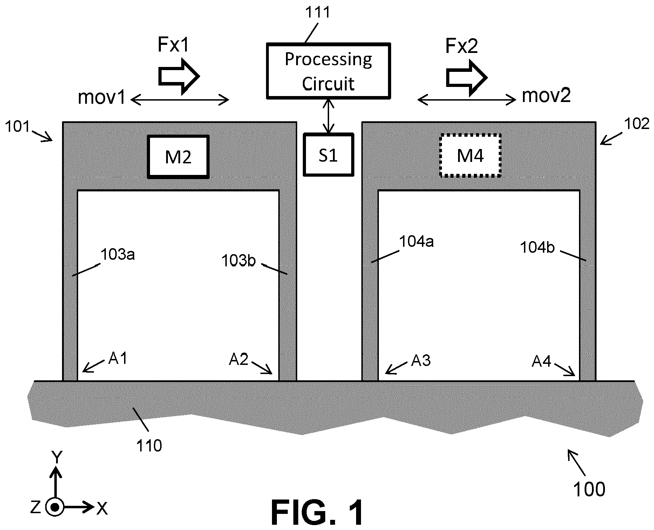

**FIG. 1** shows a schematic representation or a conceptual drawing of a MEMS structure 100. The structure 100 comprises a first platform 101, a second platform 102, and at least one sensor S1.

FIG. 1 also shows a processing circuit 111 operatively connected to said at least one sensor S1, but this circuit is not part of the actual MEMS structure. It may be implemented on the same substrate as the MEMS structure, or on a different substrate.

The first platform 101 has a main portion comprising a first material, e.g. a semiconductor material, e.g. comprising Si and/or $SiO_2$. The main portion may have a substantially rectangular cross section (in the plane XY), but that is not absolutely required.

The first platform 101 further comprises a second material M2 in the form of at least one object fixedly mounted to the first platform 101 and/or in the form of one or more strips or one or more layers disposed on or embedded in the first platform 101. The second material is a magnetic material (e.g. a soft-magnetic material, or a hard-magnetic material) having a first magnetization (e.g. first amplitude and first orientation). The first platform 101 together with the second material M2 has a first total mass.

The sensor structure 100 further comprises a first flexible suspension 103a, 103b to support or suspend the first platform 101, while allowing a first movement (indicated by arrow "mov1") of the first platform 101 in a first direction (e.g. parallel to the X-direction) caused by an ambient acceleration and/or by an ambient magnetic field having a magnetic field gradient.

The first suspension may comprise a first flexible beam 103a and a second flexible beam 103b. These beams may be substantially elongated and linear (e.g. as illustrated in FIG. 1 to FIG. 6), or may have a U-shape (e.g. as illustrated in FIG. 7 and FIG. 8), or may have a zig-zag shape (not shown), or any other suitable shape for mainly allowing movement in the X-direction while limiting movement in the Y and the Z-direction. The flexible beams 103a, 103b are anchored to a substrate 110, e.g. a semiconductor substrate, e.g. at anchor points A1, A2 respectively.

The second platform 102 may optionally further comprise a fourth material M4 in the form of at least one object fixedly mounted to the second platform 102 and/or in the form of one or more strips or one or more layers disposed on or embedded in the second platform 102. The fourth material, if present, may be a non-magnetic material, or may be a magnetic material having a second magnetization different from the first magnetization (i.e. different amplitude and/or different orientation). The second platform 102 together with the fourth material M4 (if present) has a second total mass.

Preferably, the second total mass is substantially equal to the first total mass within a tolerance margin smaller than ±10%, or smaller than ±5%, or smaller than ±2%, or smaller than ±1%, or smaller than ±0.5%.

The sensor structure 100 further comprises a second suspension 104a, 104b to support or suspend the second platform 102, while allowing a second movement (indicated by arrow "mov2") of the second platform 102 in said first direction (e.g. parallel to the X-direction) caused by said ambient acceleration and/or by said ambient magnetic field gradient.

The second suspension may comprise a third flexible beam 104a and a fourth flexible beam 104b. These beams may be substantially elongated and linear (e.g. as illustrated in FIG. 1 to FIG. 6), or may have a U-shape (e.g. as illustrated in FIG. 7 and FIG. 8), or may have a zig-zag shape (not shown), or any other suitable shape for mainly allowing movement in the X-direction while limiting movement in the Y and the Z-direction. The flexible beams 104a, 104b are anchored to the substrate 110, e.g. at anchoring points A3, A4 respectively.

The sensor device 100 further comprises at least one sensor S1, (e.g. a sensing element, or a sensing structure, e.g. a transducer) configured for measuring at least one of the following:

i) a characteristic of the first movement "mov1" relative to the substrate 110 (e.g. a displacement, or a deflection, or a first vibrational amplitude and/or frequency),

ii) a characteristic of the second movement "mov2" relative to the substrate 110 (e.g. a displacement, or a deflection, or a second vibrational amplitude and/or frequency),

iii) a characteristic of the movement of the first platform 101 relative to the second platform 102 (e.g. a relative displacement, or a relative deflection, or a vibrational amplitude and/or frequency).

FIG. 1 also shows a processing circuit 111 configured for obtaining a signal from the at least one sensor S1, and optionally further configured for determining a magnetic field gradient based on at least one signal obtained from said at least one sensing element S1, e.g. as a function of the measured signal, e.g. as a linear function or a polynomial function of the measured signal. The processing circuit may comprise a digital processor, and may comprise a non-volatile memory (e.g. flash or NVRAM), but that is not absolutely required. The processing circuit 111 may be implemented in the same substrate 110 that contains the MEMS structure, but that is not absolutely required, and the processing circuit may also be implemented on a separate substrate.

The principle of operation can be understood as follows:

- When the MEMS structure 100 is subjected or exposed to an acceleration in the X-direction, the distance between the first and second platform 101, 102 remains the same, because both platforms will react in substantially the same manner (e.g. both will displace in the positive or in the negative X-direction by the same amount). Thus, the sensor S1 will not sense any signal.
- When the MEMS structure 100 is subjected or exposed to an acceleration in the Y or Z-direction, the distance between the first and second platform 101, 102 remains the same, because the flexible suspensions only allow the platforms to substantially move in the X-direction.
- When the MEMS structure 100 is subjected or exposed to an external magnetic field having a magnetic field gradient, a force Fx1 will be exerted upon the second material M2, and thus upon the first platform 101, which can be expressed mathematically by the following formula:

$$Fx1 = Mx1 * (dBx/dx) + My1 * (dBy/dx) + Mz1 * (dBz/dx).$$

The values of Mx1, My1, Mz1 depend on the magnetization of the second material M2.

Likewise, a force Fx2 will be exerted upon the fourth material M4, and thus upon the second platform 102, which can be expressed mathematically by the following formula:

$$Fx2 = Mx2 * (dBx/dx) + My2 * (dBy/dx) + Mz2 * (dBz/dx).$$

The values of Mx2, My2, Mz2 depend on the magnetization of the fourth material M4, if present. If the fourth material is absent, or is non-magnetic, then Fx2 is equal to zero.

Since the magnetization of the second material M2 is chosen to be different from the magnetization of the fourth material M4, (if the fourth material is present at all), Fx1 will be different from Fx2 in the presence of a magnetic field gradient, and hence a distance between the two platforms 101, 102 will change. Thus, by measuring this distance (e.g. by measuring a capacitance which is dependent on said distance), a magnetic field gradient can be determined.

From the above, it can be understood that the sensor structure 100 can determine a magnetic field gradient in a manner which is highly insensitive to a mechanical acceleration in any direction. (e.g. X, Y or Z). The magnetization of the second material M2 and/or of the fourth material M4, if present, can be chosen (at the design stage) depending on which magnetic field gradient is to be measured, but is predefined once the MEMS structure is produced.

In an embodiment, the magnetization of the second material M2 is oriented in the positive or the negative X direction. In this case, the value of Mx1 is different from zero, and the value of My1 and Mz1 are substantially equal to zero. In this case, preferably the magnetization of the fourth material M4 is either zero, or is also oriented in the positive or negative X direction, but has a different magnitude than that of the second material, thus Mx2 is different from zero, while My2 and Mz2 are substantially equal to zero. This configuration is very much suited for measuring the magnetic field gradient dBx/dx.

In an embodiment, the magnetization of the second material M2 is oriented in the positive or the negative Y direction. In this case, the value of My1 is different from zero, and the value of Mx1 and Mz1 are substantially equal to zero. In this case, preferably the magnetization of the fourth material M4 is either zero, or is also oriented in the positive or negative Y direction, but has a different magnitude than that of the second material, thus My2 is different from zero, while Mx2 and Mz2 are substantially equal to zero. This configuration is very much suited for measuring the magnetic field gradient dBy/dx.

In an embodiment, the magnetization of the second material M2 is oriented in the positive or the negative Z direction. In this case, the value of Mz1 is different from zero, and the value of Mx1 and My1 are substantially equal to zero. In this case, preferably the magnetization of the fourth material M4 is either zero, or is also oriented in the positive or negative Z direction, but has a different magnitude than that of the second material, thus Mz2 is different from zero, while Mx2 and My2 are substantially equal to zero. This configuration is very much suited for measuring the magnetic field gradient dBz/dx.

In an embodiment, the fourth material is also magnetic, and the magnetization of the fourth material M4 is equally large, but oriented in the opposite direction as the magnetization of the second material M2. This embodiment has the advantage that the displacement or deflection is twice as large as compared to an embodiment in which the fourth material M4 is absent. Thus this embodiment provides a signal with an improved signal-to-noise ratio, and thus a better accuracy.

But the present invention is not limited to these examples, and the magnetization of the second material M2 may also be oriented for example in a direction forming an angle of about 45° with the X-direction, and forming an angle of 45° with the Y-direction, and forming an angle of about 0° with the Z-direction. This configuration may be used for example, for detecting "a" magnetic field gradient oriented in the X-direction or the Y-direction, or a direction between X and Y.

Many variants are possible, some of which will be described further.

The at least one sensor S1 may be or may comprise a capacitive sensor, a piezoelectrical sensor, a piezoresistive sensor, an optical sensor, or combinations hereof.

The substrate may be a silicon substrate, or a CMOS substrate.

In an embodiment, the substrate is a silicon-on-insulator "SOI"-substrate.

In an embodiment, one of the first platform 101 and the second platform 102 is implemented mainly in a lower silicon layer of the SOI substrate (also referred to as "bulk"), and the other of said first and second platform is implemented mainly in an upper silicon layer of the SOI substrate (also referred to as "device layer"), or vice versa. The upper layer (or device layer) may have a first thickness, and the lower layer (bulk, or "handle layer") may have a second thickness different from the first thickness. The thickness of the bulk layer may be 2.0 to 20.0 times larger than the thickness of the device layer, or 2.0 to 10.0 times larger, or 3.0 to 7.0 times, or 4.0 to 6.0 times. In an example, the device layer has a thickness in the range from 15 $\mu$m to 50 $\mu$m, e.g. equal to about 20 $\mu$m, and the handle layer has a thickness in the range from 100 $\mu$m to 800 $\mu$m, e.g. equal to about 500 $\mu$m.

In an embodiment, the first platform 101 may have a cavity (not explicitly shown), and the second magnetic material M2 is present in the form of a discrete object mounted inside said cavity.

In an embodiment, at least a portion of the second magnetic material M2 is sputtered on the first platform 101.

The second material M2 may comprise a magnetic material such as e.g. FeNi or NdFeB or an alloy comprising any combination of Co, Fe and Ni. The same applies for the fourth material if that is also a magnetic material.

In case the fourth material M4 is a non-magnetic material, it may comprise e.g. a semiconductor material (e.g. Si) or silicon-dioxide, but that his not absolutely required, and the fourth material may also be a metal or an alloy comprising e.g. Tungsten or Stainless steel. An advantage is that a smaller volume of fourth material is required (as compared to Si) for substantially matching the first total mass and the second total mass.

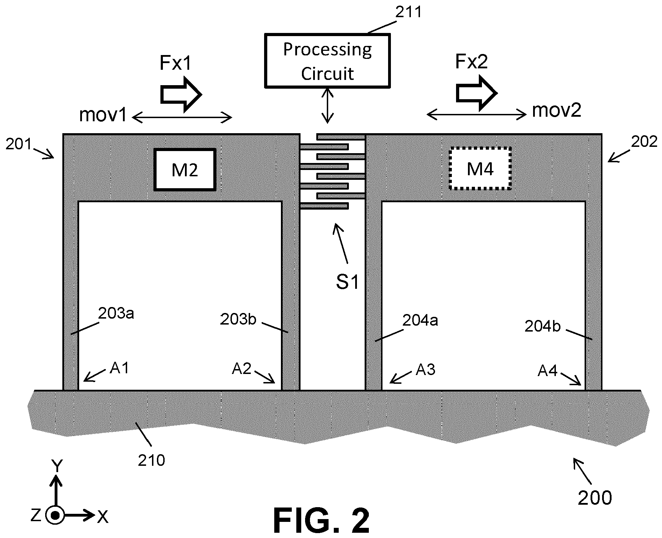

FIG. 2 shows a special case of FIG. 1, wherein the sensor S1 is a capacitive sensor. The capacitive sensor may be configured for measuring a capacitance indicative of a distance or displacement of the first platform 201 relative to the second platform 202. The capacitive sensor S1 may be a variable capacitor comprising a plurality of parallel plate electrodes or linear comb fingers. It is noted in this respect that the drawing is only a schematic representation, and is not necessarily drawn to scale. Capacitive sensors and circuits for reading them are known in the art, are not the main focus of the present invention, and hence need not be described in more detail here. It suffices to say that a capacitive sensor may be provided with a DC signal or with an AC signal, e.g. with a pulse signal, and that a resulting output voltage changes due to the change in the capacitance of the sensing element caused by the motion of the platforms. The sensor readout circuit may comprise an amplifier, an analog-to-digital convertor (ADC), a filter, e.g. a low-pass filter or a band-pass-filter, etc. Everything else described above for the MEMS structure of FIG. 1 is also applicable here.

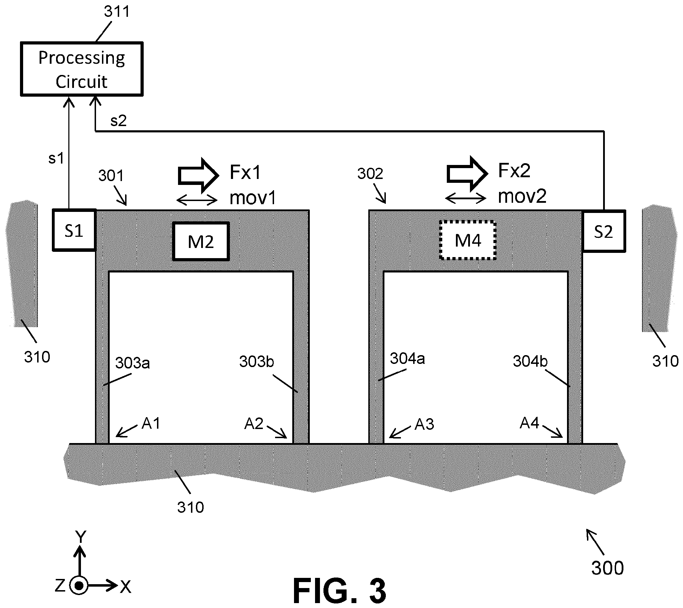

FIG. 3 shows a MEMS structure 300 which can be seen as a variant of the MEMS structure 100 of FIG. 1. The main differences are that the MEMS structure 300 has two sensors, namely a first sensor S1 for measuring a displacement of the first platform 301 relative to the substrate 310, and a second sensor S2 for measuring a displacement of the second platform 302 relative to the substrate 310, and that the processing circuit 311 receives a signal s1, s2 from the first and the second sensor S1, S2 respectively.

In an embodiment, the magnetic field gradient may be determined as a function of the measured signals s1 and s2, e.g. in accordance with the formula: gradient = f(s1, s2), where f() is a predefined function.

In a particular embodiment, the magnetic field gradient may be determined in accordance with the formula: gradient = $K^*(s1-s2-C_0)$, where K and $C_0$ are predefined constants.

In another embodiment (not shown), the differential displacement between the first platform 301 and the second platform 302 is measured, and this differential displacement may subsequently be converted into a magnetic field gradient value.

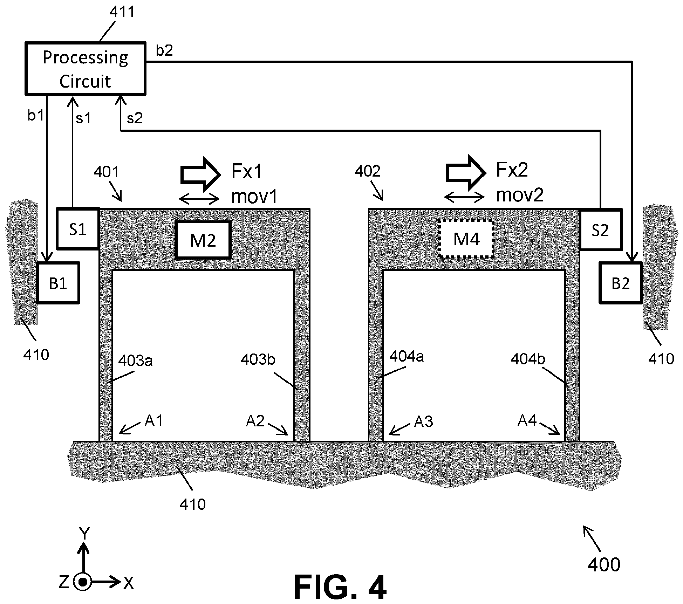

**FIG. 4** shows a MEMS structure 400 which can be seen as a variant of the MEMS structure 300 of FIG. 3. The main differences are that the MEMS structure 400 of FIG. 4 further comprises one or more actuators B1, B2 for biasing or actuating (e.g. statically, or dynamically, or bringing into oscillation) the first platform 401 and/or the second platform 402. In the example shown in FIG. 4, the first platform 401 has an actuator B1, and the second platform 402 has a second actuator B2, but that is not absolutely required.

The actuators may be tapered comb drives. When a static bias voltage is placed on such a comb drive, an attractive electrostatic force increases linearly with the displacement. This is equivalent to a mechanical spring with a negative spring constant. As the mechanical spring is in parallel with the actuated tapered comb drive, the equivalent spring constant of the platform attachment is reduced. The mechanical sensitivity of the system can be expressed by (m/k) where m is the total mass of the platform and k the total spring constant. The tuning of the spring constants allows therefore the vibration sensitivities of the two platforms to be matched electrostatically, even when their masses are different.

The processing circuit 411 may be further configured for providing a biasing signal or actuator signal b1 to the first actuator B1, and a second biasing signal or actuator signal b2 to the second actuator B2, but that is not absolutely required, and it is also possible to provide a "biasing or actuating circuit" for providing the biasing or actuating signal(s) b1, b2.

The processing circuit 411 may be configured for filtering (e.g. low-pass filtering or band-pass-filtering) the signals s1, s2 obtained from the sensors S1, S2. Everything else described above is also applicable here.

In a variant (not shown) of FIG. 4, the MEMS structure 400 has only a single sensor S1 configured for measuring a displacement of the first platform 401 relative to the second platform 402 (e.g. as in FIG. 1 or FIG. 2).

In another or a further variant (not shown) of FIG. 4, the MEMS structure 400 has only a single actuator (e.g. B2 but not B1) arranged for biasing or actuating the second platform 402 relative to the first platform 401, for pushing the second platform 402 away from the first platform 401, and/or for pulling the second platform 402 towards the first platform 401. In this case, the processing circuit would have to provide only a single biasing or actuating signal.

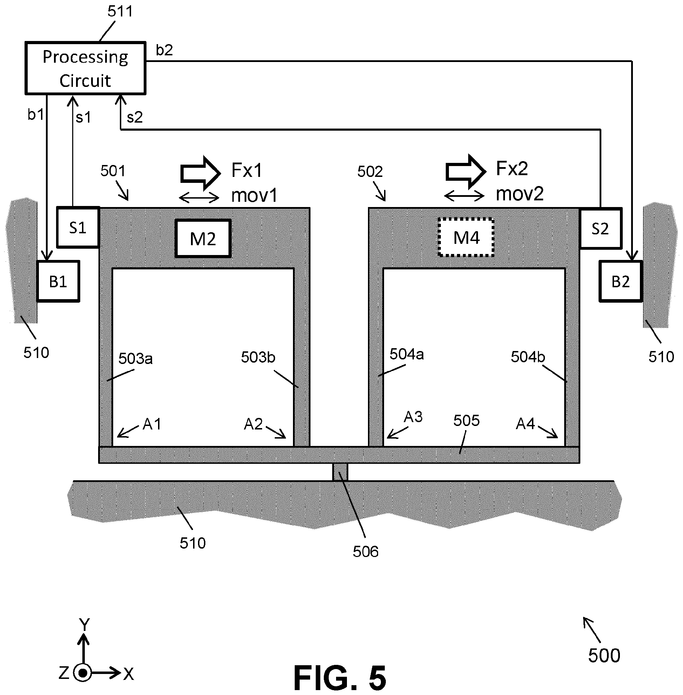

**FIG. 5** shows a MEMS structure 500 which can be seen as a variant of the MEMS structure 400 of FIG. 4. The main difference is that the MEMS structure 500 comprises an elongated support beam 505, and that the first suspension e.g. comprising the beams 503a, 503b and the second suspension e.g. comprising the beams 504a, 504b are anchored, at the anchoring points A1 to A4 respectively, to said support beam 505. The support beam 505 itself is preferably an elongated beam extending in the first direction (X), and is preferably suspended from the substrate 510 at anchoring point 506. The anchoring point 506 is preferably situated between the anchoring points A1 and A4, more preferably between the anchoring points A2 and A3, even more preferable substantially in the middle between A2 and A3, or substantially in the middle of the length of the support beam 505.

In a variant (not shown) of FIG. 5, the MEMS structure 500 has only a single sensor S1 configured for measuring a displacement of the first platform 501 relative to the second platform 502 (e.g. as in FIG. 1 or FIG. 2).

In another or a further variant (not shown) of FIG. 5, the MEMS structure 500 has only a single actuator (e.g. B2 but not B1) arranged for biasing or actuating the second platform 502 relative to the first platform 501.

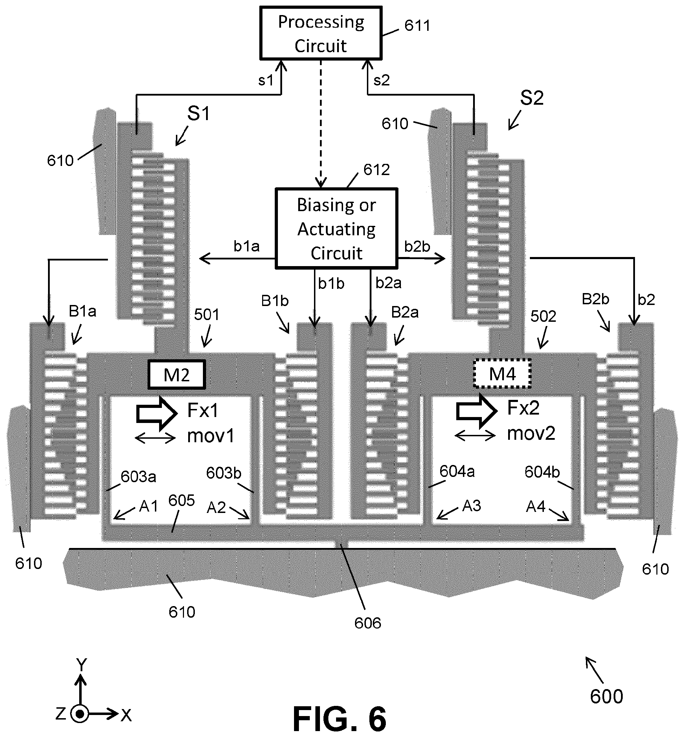

**FIG. 6** shows a MEMS structure 600 which can be seen as a more detailed version or a variant of the MEMS structure 500 of FIG. 5, wherein the actuator B1 comprises two comb structures: B1a arranged in the vicinity of the first beam 603a, and B1b arranged in the vicinity of the second beam 603b; and wherein the actuator B2 comprises also two comb structures: B2a arranged in the vicinity of the third beam 604a, and B2b arranged in the vicinity of the fourth beam 604b. As can be seen, the sensor signals s1, s2 obtained from the sensors S1, S2 are routed to the processing circuit 611, and the biasing or actuating signals b1a, b1b, b2a, b2b provided to the actuators B1a, B1b, B2a, B2b respectively, are routed to a Biasing or Actuation Circuit 612. The biasing circuit(s) may be used to match a resonance frequency of the first platform 601 to a resonance frequency of the second platform 602.

The MEMS structure can be brought into oscillation with a high quality factor. This high quality factor can be achieved when the resonance frequencies of the two platforms are closely (e.g. exactly) matched. The complete structure then represents a tuning fork whose symmetry prevents any mechanical energy to be lost, which implies a high quality factor. The quality factor may be further increased by lowering a gas pressure of the medium in which the structure operates, as this removes energy losses to the gas. The sensitivity of a structure in resonance to small perturbations is multiplied by the quality factor as compared to the same structure that is not in resonance. A resonant sensor can therefore achieve a much higher sensitivity as compared to a non-resonant version.

**FIG. 7** shows an illustrative example of a practical implementation of a MEMS structure 700, in perspective view, and **FIG. 8** shows the MEMS structure 700 of FIG. 7 in top view.

In a particular embodiment, the platforms 701, 702 are implemented in a Silicon-In-Insulator SOI substrate, and the comb fingers are implemented in the top layer of the SOI substrate. It is noted that the actual sensors (e.g. capacitive comb structures) are not shown in FIG. 7 and FIG. 8, in order not to obscure the drawings.

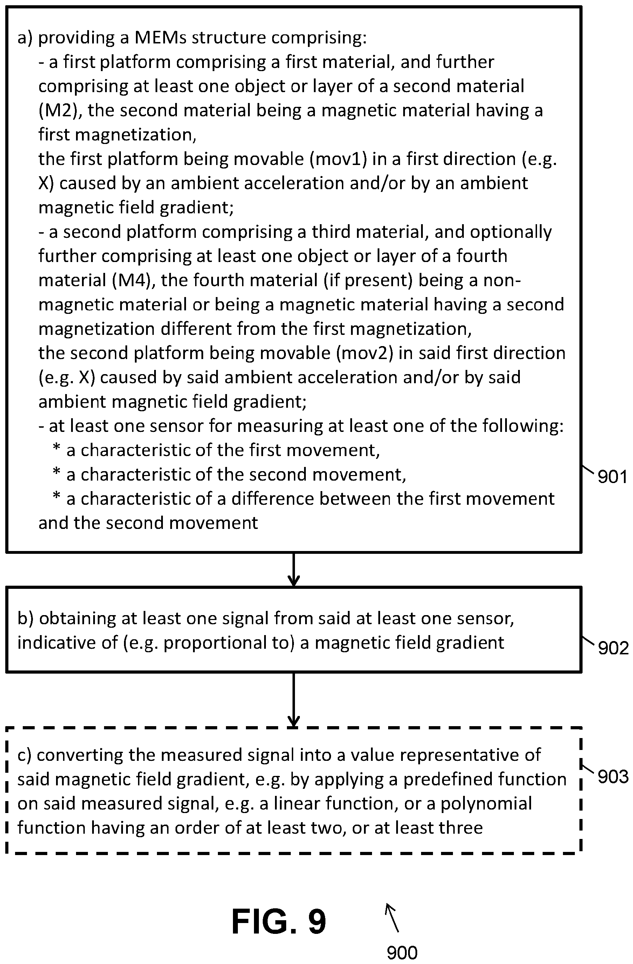

**FIG. 9** shows a flow-chart of a method 900 of measuring a magnetic field gradient, or at least a signal indicative of a magnetic field gradient. The method comprises the steps of:

a) providing in step 901 a MEMS structure comprising:

- a first platform comprising a first material, and further comprising at least one layer or object of a second material M2, the second material being a magnetic material having a first magnetization, the first platform being movable (mov1) in a first direction (e.g. X) caused by an ambient acceleration and/or by an ambient magnetic field gradient;
- a second platform comprising a third material, and optionally further comprising at least one layer or object of a fourth material (M4), the fourth material (if present) being a non-magnetic material or being a magnetic material having a second magnetization different from the first magnetization, the second platform being movable (mov2) in said first direction (e.g. X) caused by said ambient acceleration and/or by said ambient magnetic field gradient;
- at least one sensor for measuring at least one of the following: a characteristic of the first movement, a characteristic of the second movement, a characteristic of a difference between the first and the second movement;

b) obtaining in step 902 at least one signal from said at least one sensor, indicative of (e.g. proportional to) a magnetic field gradient.

The method may comprise a further step:
c) converting in step 903 the measured signal into a value representative of said magnetic field gradient, e.g. by applying a predefined function on said measured signal, e.g. a linear function, or a polynomial function having an order of at least two, or at least three.

The MEMS structure provided in step a) may be any of the MEMS structure described above in FIG. 1 to FIG. 8, or variants thereof.

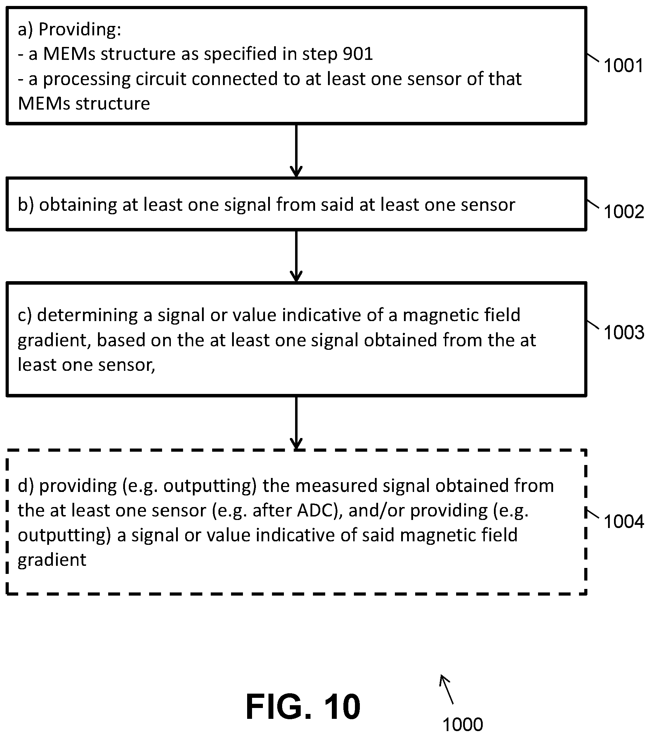

**FIG. 10** shows a flow-chart of a method 1000 of measuring a magnetic field gradient, or a signal indicative of a magnetic field gradient, as may be performed by a processing circuit connected to a MEMS structure as illustrated in FIG. 1 to FIG. 8. This processing circuit may be incorporated in an integrated sensor device, together with the MEMS structure. The method 1000 comprises the following steps:

a) providing in step 1001 a MEMS structure as specified in step 901 of FIG. 9, and a processing circuit connected to the at least one sensor of that MEMS structure;
b) obtaining in step 1002 at least one signal from said at least one sensor;
c) determining in step 1003 a signal or value indicative of a magnetic field gradient, based on the at least one signal obtained from the at least one sensor.

The method 1000 may further comprise the following step:
d) providing in step 1004 (e.g. outputting) the measured signal obtained from the at least one sensor (e.g. after ADC), and/or providing (e.g. outputting) a signal or value indicative of said magnetic field gradient.

REFERENCES module 100:

-00    MEMS structure
-01    first platform
-02    second platform
-03a    first beam
-03b    second beam
-04a    third beam
-04b    second beam
-05    support beam
-06    anchor of support beam
-07    comb fingers of first platform
-08    comb fingers of second platform
-10    substrate
-11    processing circuit
-12    biasing or actuating circuit

Other References:

A1, A2, A3, A4   first, second, third, fourth anchoring point
S1, S2   first, second sensor
B1, B2   first, second biasing means or actuator
M2, M4   second, fourth material
mov1   movement (e.g. displacement or vibration) of first platform along X-direction
mov2   movement (e.g. displacement or vibration) of second platform along X-direction

**Claims**

1. A MEMS structure (100; 200; 300; 400; 500; 600; 700; 800) comprising:

   a first platform (101; 201; 301; 401; 501; 601; 701; 801) comprising a first material, and further comprising at least one object or at least one layer of a second material (M2) embedded in or mounted to or disposed on the first platform, the second material being a magnetic material having a first magnetization;
   a first flexible suspension anchored to a substrate (110; 210; 310; 410; 510; 610) to support or suspend the first platform, while allowing a first movement of the first platform in a first direction (X) caused by an ambient force or acceleration and/or by an ambient magnetic field gradient;
   a second platform (102; 202; 302; 402; 502; 602; 702; 802) comprising a third material, and optionally further comprising at least one object or at least one layer of a fourth material (M4) embedded in or mounted to or disposed on the second platform, the fourth material being a non-magnetic material or being a magnetic material having a second magnetization different from the first magnetization;
   a second flexible suspension anchored to said substrate to support or suspend the second platform, while allowing a second movement of the second platform in said first direction (X) caused by said ambient force or acceleration and/or by said ambient magnetic field gradient;
   at least one sensor (S1; S1, S2) configured for measuring at least one of the following: a characteristic of the first movement, a characteristic of the second movement, a characteristic of a difference between the first movement and the second movement.

2. A MEMS structure (100; 200; 300; 400; 500; 600; 700; 800) according to claim 1,

   wherein the first platform (101; 201; 301; 401; 501; 601; 701; 801) together with the second material (M2) has a first total mass;
   and wherein the second platform (102; 202; 302; 402; 502; 602; 702; 802) together with the fourth material (M4), if present, has a second total mass;
   and wherein the first total mass is substantially equal to the second total mass within a tolerance margin smaller than ±10%.

3. A MEMS structure (100; 200; 300; 400; 500; 600; 700; 800) according to any of the previous claims,

   wherein the first suspension comprises a first flexible beam (103a; 203a; 303a; 403a; 503a; 603a; 703a; 803a) and a second flexible beam (103b; 203b; 303b; 403b; 503b; 603b; 703b; 803b);
   and wherein the second suspension comprises a third flexible beam (104a; 204a; 304a; 404a; 504a; 604a; 704a; 804a) and a fourth flexible beam (104b; 204b; 304b; 404b; 504b; 604b; 704b; 804b).

4. A MEMS structure (500; 600) according to any of the previous claims,

   further comprising a support beam (505; 605) suspended to the substrate (510, 610);
   wherein the support beam (505; 605) is connected to the substrate (510, 610) near a middle of the support beam;
   and wherein the first suspension (503a, 503b; 603a, 603b) and the second suspension (504a, 504b; 604a, 604b) are connected to said support beam (505; 605) on opposite sides of said middle.

5. A MEMS structure according to any of the previous claims,

   wherein the at least one sensor is configured for providing a signal indicative of a displacement of the first platform relative to the second platform;
   or wherein the at least one sensor is configured for providing a signal indicative of a displacement of the first platform relative to the substrate.

**6.** A MEMS structure according to any of the previous claims,
wherein the at least one sensor comprises a capacitive sensor, or a piezoelectrical sensor, or a piezoresistive sensor, or an optical sensor.

**7.** A MEMS structure according to any of the previous claims,
wherein the substrate (110; 210; 310; 410; 510; 610) is a silicon-on-insulator (SOI) substrate.

**8.** A MEMS structure according to any of the previous claims,

wherein the first platform (101; 201; 301; 401; 501; 601; 701; 801) has a cavity;
and wherein the second material (M2) is part of a discrete object that is mounted or positioned inside said cavity.

**9.** A MEMS structure according to any of the claims 1 to 7,
wherein at least a portion of the second material (M2) is sputtered on the first platform (101; 201; 301; 401; 501; 601; 701; 801).

**10.** A MEMS structure according to any of the previous claims,

wherein the second material (M2) is a magnetic material;
and wherein the fourth material (M4) is a semiconductor material or an oxide or a non-magnetic metal or a non-magnetic metal alloy.

**11.** A MEMS structure (400; 500; 600) according to any of the previous claims,
further comprising at least one actuator (B1, B2; B1a, B1b, B2a, B2b) for biasing one or both of the first platform and the second platform.

**12.** A MEMS structure (400; 500; 600) according to any of the claims 1 to 10,

further comprising a first actuator (B1; B1a, B1b) for causing an oscillation of the first platform; and
further comprising a second actuator (B2; B2a, B2b) for causing an oscillation of the second platform.

**13.** A sensor device comprising:

only one MEMS structure according to any of the previous claims;
or only two MEMS structures according to any of the previous claims, configured for measuring two magnetic field gradients;
or three MEMS structure according to any of the previous claims, configured for measuring three magnetic field gradients;
or four MEMS structure according to any of the previous claims, configured for measuring four magnetic field gradients;
or six MEMS structure according to any of the previous claims, configured for measuring six magnetic field gradients.

**14.** The sensor device of claim 13, further comprising a circuit configured for determining and optionally outputting one or more signals or values indicative of one or more magnetic field gradients, or one or more signals derived therefrom, based on the one or more signals obtained from the at least one sensor of the one or more MEMS structures.

**15.** Method (900) of measuring a signal indicative of a magnetic field gradient, comprising the steps of:

a) providing (901) a MEMS structure according to any of the claims 1 to 12, or providing a sensor device according to claim 13 or 14;
b) obtaining (902) at least one signal from the at least one sensor of the MEMS structure, the signal being a characteristic of a mechanical movement, which in turn is indicative of a magnetic field gradient.

FIG. 1

FIG. 2

FIG. 3

FIG. 4

**FIG. 5**

**FIG. 6**

**FIG. 7**

**FIG. 8**

a) providing a MEMs structure comprising:
- a first platform comprising a first material, and further comprising at least one object or layer of a second material (M2), the second material being a magnetic material having a first magnetization,
the first platform being movable (mov1) in a first direction (e.g. X) caused by an ambient acceleration and/or by an ambient magnetic field gradient;
- a second platform comprising a third material, and optionally further comprising at least one object or layer of a fourth material (M4), the fourth material (if present) being a non-magnetic material or being a magnetic material having a second magnetization different from the first magnetization,
the second platform being movable (mov2) in said first direction (e.g. X) caused by said ambient acceleration and/or by said ambient magnetic field gradient;
- at least one sensor for measuring at least one of the following:
 * a characteristic of the first movement,
 * a characteristic of the second movement,
 * a characteristic of a difference between the first movement and the second movement

901

b) obtaining at least one signal from said at least one sensor, indicative of (e.g. proportional to) a magnetic field gradient

902

c) converting the measured signal into a value representative of said magnetic field gradient, e.g. by applying a predefined function on said measured signal, e.g. a linear function, or a polynomial function having an order of at least two, or at least three

903

# FIG. 9

900

a) Providing:
- a MEMs structure as specified in step 901
- a processing circuit connected to at least one sensor of that
MEMs structure

⤻1001

b) obtaining at least one signal from said at least one sensor

⤻1002

c) determining a signal or value indicative of a magnetic field
gradient, based on the at least one signal obtained from the at
least one sensor,

⤻1003

d) providing (e.g. outputting) the measured signal obtained from
the at least one sensor (e.g. after ADC), and/or providing (e.g.
outputting) a signal or value indicative of said magnetic field
gradient

⤻1004

# FIG. 10

1000

EUROPEAN SEARCH REPORT

**Application Number**

EP 23 17 3266

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 972 417 B1 (INVENSENSE INC [US]) 2 May 2018 (2018-05-02) * paragraphs [0011] – [0022]; figures 1-10 * | 1-3,5,6, 13-15 | INV. G01R33/022 G01R33/028 G01P15/08 |
| X | EP 1 790 986 B1 (TDK CORP [JP]) 12 January 2011 (2011-01-12) | 1-10, 13-15 | |
| Y | * paragraphs [0041], [0042]; figures 2-4, 8-10 * | 11 | |
| X | EP 1 521 071 A2 (FIAT RICERCHE [IT]) 6 April 2005 (2005-04-06) * paragraphs [0002], [0032] – [0053]; figures 4-6 * | 1,8-10 | |
| Y | WO 2006/106458 A1 (KONINKL PHILIPS ELECTRONICS NV [NL]; PHAN LE KIM [NL] ET AL.) 12 October 2006 (2006-10-12) * pages 6, 7, 13, 14; figures 15, 16 * | 1-15 | |
| Y | US 11 567 147 B1 (KUBENA RANDALL L [US] ET AL) 31 January 2023 (2023-01-31) * figure 10 * | 1-15 | TECHNICAL FIELDS SEARCHED (IPC) G01R G01P |
| Y | US 2011/140692 A1 (CLASSEN JOHANNES [DE] ET AL) 16 June 2011 (2011-06-16) * paragraphs [0036], [0043], [0103], [0105]; figures 1, 2 * | 1-15 | |

-/--

The present search report has been drawn up for all claims

| Place of search | Date of completion of the search | Examiner |
|---|---|---|
| Munich | 23 October 2023 | Philipp, Peter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**page 1 of 2**

Europäisches
Patentamt

European
Patent Office

Office européen
des brevets

# EUROPEAN SEARCH REPORT

**Application Number**

**EP 23 17 3266**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Javor Josh ET AL: "100?pT/cm single-point MEMS magnetic gradiometer from a commercial accelerometer ¦ Microsystems & Nanoengineering", Microsystems & Nanoengineering, 10 August 2020 (2020-08-10), XP093093955, Retrieved from the Internet: URL:https://www.nature.com/articles/s41378-020-0173-z [retrieved on 2023-10-23] * abstract * ----- | 1-15 | |
| A | US 2005/270014 A1 (ZRIBI ANIS [US] ET AL) 8 December 2005 (2005-12-08) * figure 3 * ----- | 1-15 | |

| | | | TECHNICAL FIELDS SEARCHED (IPC) |
|---|---|---|---|

The present search report has been drawn up for all claims

| Place of search | Date of completion of the search | Examiner |
|---|---|---|
| Munich | 23 October 2023 | Philipp, Peter |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 17 3266

This annex lists the patent family members relating to the patent documents cited in the above-mentioned European search report.
The members are as contained in the European Patent Office EDP file on
The European Patent Office is in no way liable for these particulars which are merely given for the purpose of information.

23-10-2023

| Patent document cited in search report | | Publication date | Patent family member(s) | | Publication date |
|---|---|---|---|---|---|
| EP 2972417 | B1 | 02-05-2018 | CN | 105358990 A | 24-02-2016 |
| | | | EP | 2972417 A1 | 20-01-2016 |
| | | | KR | 20150132411 A | 25-11-2015 |
| | | | US | 2014266170 A1 | 18-09-2014 |
| | | | WO | 2014151370 A1 | 25-09-2014 |
| EP 1790986 | B1 | 12-01-2011 | CN | 1971283 A | 30-05-2007 |
| | | | EP | 1790986 A2 | 30-05-2007 |
| | | | JP | 4367403 B2 | 18-11-2009 |
| | | | JP | 2007147303 A | 14-06-2007 |
| | | | US | 2007119253 A1 | 31-05-2007 |
| EP 1521071 | A2 | 06-04-2005 | AT | 495428 T | 15-01-2011 |
| | | | EP | 1521071 A2 | 06-04-2005 |
| WO 2006106458 | A1 | 12-10-2006 | NONE | | |
| US 11567147 | B1 | 31-01-2023 | NONE | | |
| US 2011140692 | A1 | 16-06-2011 | CN | 102095893 A | 15-06-2011 |
| | | | DE | 102009046807 A1 | 19-05-2011 |
| | | | IT | 1402870 B1 | 27-09-2013 |
| | | | TW | 201140061 A | 16-11-2011 |
| | | | US | 2011140692 A1 | 16-06-2011 |
| US 2005270014 | A1 | 08-12-2005 | AT | E374952 T1 | 15-10-2007 |
| | | | DE | 602005002683 T2 | 17-07-2008 |
| | | | EP | 1610142 A1 | 28-12-2005 |
| | | | US | 2005270013 A1 | 08-12-2005 |
| | | | US | 2005270014 A1 | 08-12-2005 |
| | | | US | 2007040547 A1 | 22-02-2007 |
| | | | US | 2007052410 A1 | 08-03-2007 |
| | | | US | 2008070338 A1 | 20-03-2008 |

EPO FORM P0459

For more details about this annex : see Official Journal of the European Patent Office, No. 12/82

**REFERENCES CITED IN THE DESCRIPTION**

**Patent documents cited in the description**

- WO 2014151370 A1